Europäisches Patentamt

**European Patent Office**

**Office européen des brevets**

(19)

(11) Veröffentlichungsnummer: **0 262 435**

**A2**

(12) **EUROPÄISCHE PATENTANMELDUNG**

(21) Anmeldenummer: **87112820.3**

(22) Anmeldetag: **02.09.87**

(51) Int. Cl.⁴: **H01S 3/08** , G02B 6/26

(30) Priorität: **29.09.86 DE 3632998**

(43) Veröffentlichungstag der Anmeldung:
**06.04.88 Patentblatt 88/14**

(84) Benannte Vertragsstaaten:
**DE FR GB**

(71) Anmelder: **Siemens Aktiengesellschaft Berlin und München**
**Wittelsbacherplatz 2**
**D-8000 München 2(DE)**

(72) Erfinder: **Häussler, Klaus-M., Dr.**
**Hildebrandstrasse 13**
**D-8000 München 19(DE)**
Erfinder: **Wittmann, Julius, Dipl.-Ing.**
**Innerer Stockweg 7**
**D-8024 Oberhaching(DE)**
Erfinder: **Gaukel, Gisela, Dipl.-Phys.**
**Görrestrasse 17**
**D-8000 München 40(DE)**
Erfinder: **Auracher, Franz, Dr.**
**Eichenstrasse 26**
**D-8021 Baierbrunn(DE)**

(54) **Schmalbandiger Lasersender mit einem externen Resonator, bei dem die Ausgangsleistung dem Resonator entnehmbar ist.**

(57) Schmalbandiger Lasersender (LS) mit einem Halbleiterlaser (HL) und einem an dem Halbleiterlaser (HL) gekoppelten externen optischen Resonator (ER), wobei eine Ausgangsleistung des Senders (LS) dem Resonator (ER) entnehmbar ist. Es wird ein Gestaltungskonzept für einen Lasersender dieser Art angegeben, bei dem sowohl eine mikrooptische Ausführung als auch eine Ausführung mit freier Strahlausbreitung möglich ist. Dazu besteht der Resonator (ER) aus einer im Strahlengang (St) einer von dem Halbleiterlaser (HL) emittierten Laserstrahlung angeordneten optischen Gittereinrichtung (GE), die einen Teil (St1) der zugeführten Laserstrahlung zurück zum Halbleiterlaser (HL) und einen anderen Teil (St2) dieser Strahlung zu einer Koppelstelle (KS) leitet, an der dieser andere Teil (St2) als Ausgangsleistung entnehmbar ist.

FIG 1

EP 0 262 435 A2

## Schmalbandiger Lasersender mit einem externen Resonator, bei dem die Ausgangsleistung dem Resonator entnehmbar ist

Die vorliegende Erfindung betrifft einen - schmalbandigen Lasersender mit einem externen Resonator nach dem Oberbegriff des Patentanspruchs 1, bei dem also die Ausgangsleistung aus dem Resonator entnommen wird, der eine Wellenlängenselektivität des Senders bewirkt.

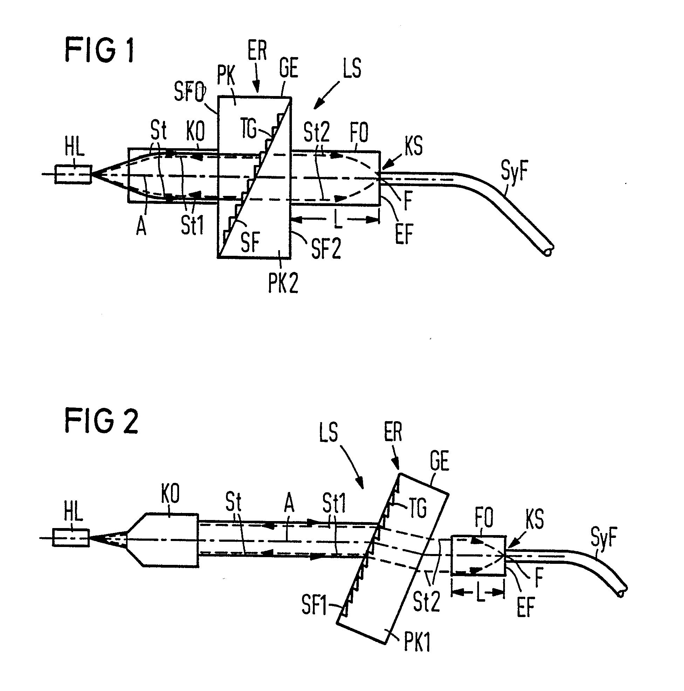

Ein Sender der genannten Art ist in der älteren deutschen Patentanmeldung P 36 00 726.9 (VPA 86 P 1006 DE) vorgeschlagen (siehe dort Fig. 2 und dazugehörigen Beschreibungsteil).

Bei diesem vorgeschlagenen Sender ist der externe optische Resonator in Form eines optischen Richtkopplers ausgebildet, der aus zwei in einer bestimmten Koppelstrecke in derart geringem Abstand verlaufenden Wellenleitern besteht, daß in der Koppelstrecke eine Leistungsüberkopplung zwischen den Wellenleitern auftritt. Einer der beiden Wellenleiter ist an den Halbleiterlaser angekoppelt. Die in diesen Wellenleiter eingekoppelte Laserstrahlung ist einer teildurchlässigen Rückkopplungseinrichtung zugeleitet, die einen Teil der Laserstrahlung in die Koppelstrecke zurückleitet. Der von der Rückkopplungseinrichtung durchgelassene Teil der Laserstrahlung wird durch einen schleifenförmigen optischen Wellenleiter dem anderen Wellenleiter des Richtkopplers zugeleitet. An diesem anderen Wellenleiter wird die Ausgangsleistung des Senders entnommen.

Mit einem derartigen Lasersender kann ein extrem schmalbandiger, einmodiger Betriebszustand erreicht werden, wie er für zukünftige faseroptische Nachrichtensysteme, insbesondere mit Heterodyn- oder Homodynempfang erforderlich ist.

Ein derartiger Lasersender weist den Vorteil auf, daß die Ankopplung des Resonators und einer Systemfaser an den Halbleiterlaser auf nur einer Seite des Halbleiterlasers erfolgt, im Gegensatz zu anderen Ausführungsformen solcher Lasersender, bei denen die Systemfaser auf einer Seite und der Resonator auf der gegenüberliegenden Seite an den Halbleiterlaser angekoppelt sind. Durch die einseitige Ankopplung werden Justierprobleme erheblich vermindert und es kann dem Erfordernis einer hohen mechanischen Stabilität bei der Ankopplung der Systemfaser und des externen Resonators besser entsprochen werden.

Aufgabe der Erfindung ist es, ein Gestaltungskonzept für einen Lasersender der eingangs genannten Art anzugeben, bei dem sowohl eine mikrooptische Ausführung als auch eine Ausführung mit freier Strahlausbreitung des Lasersenders möglich ist.

Diese Aufgabe wird durch die im kennzeichnenden Teil des Patentanspruchs 1 angegebenen Merkmale gelöst.

Durch die Rückreflexion eines Teils der ausgestrahlten Laserleistung kann ein einmodiger Laserbetrieb mit schmaler Linienbreite erzwungen werden.

Bevorzugte und vorteilhafte Ausgestaltungen der bei dem erfindungsgemäßen Lasersender verwendeten Gittereinrichtung gehen aus den Ansprüchen 2 bis 8 hervor.

Besonders vorteilhaft ist es, einen erfindungsgemäßen Laser nach Maßgabe des Anspruchs 9 zu gestalten. Die von der Kollimierungsoptik erzeugte kollimierte Laserstrahlung optimiert die wellenlängenselektive Wirkung der Gittereinrichtung. Durch die Kombination der Gittereinrichtung mit der Kollimierungsoptik wird nur ein schmaler Wellenlängenbereich in sich zum Halbleiterlaser zurückgeleitet und wieder auf diesen fokussiert. Dies ist insbesondere der Fall, wenn die Kollimierungsoptik gemäß Anspruch 10 aus einer Gradientenlinse besteht (siehe dazu IEEE J. Quant. Electronics QE-16 (1980) S. 11-22). Die Ausführungsform nach Anspruch 10 eignet sich insbesondere in ihrer Ausgestaltung nach Anspruch 11 für eine mikrooptische Ausführung des erfindungsgemäßen Lasersenders.

Eine Ausführung des erfindungsgemäßen Lasersenders mit freier Strahlausbreitung weist vorzugsweise die Merkmale des Anspruchs 12 auf.

Zweckmäßigerweise ist bei einem erfindungsgemäßen Lasersender eine Fokussierungsoptik nach Maßgabe des Anspruchs 13 vorgesehen, die vorzugsweise nach Anspruch 14 aus einer Gradientenlinse besteht und insbesondere für die mikrooptische Ausführung, aber auch für die Ausführung mit freier Strahlausbreitung verwendet wird.

Besonders vorteilhaft ist es, die fokussierende Gradientenlinse gemäß Anspruch 15 zu gestalten. Dadurch kann eine die Ausgangsleistung des Lasersenders fortleitende Systemfaser direkt an die Gradientenlinse stoßgekoppelt werden.

Im Hinblick auf eine mirkooptische Ausführung des Lasersenders ist es zweckmäßig, den Sender nach Anspruch 14 oder 15 so auszuführen, wie es im Anspruch 16 angegeben ist.

Wird ein zusätzlicher Monitorausgang benötigt, beispielsweise für Regelungszwecke, so kann bei dem erfindungsgemäßen Laser ein zusätzlicher Strahlteiler in einem seiner Strahlengänge vorgesehen sein, der einen Teil der betreffenden Strahlung für Monitorzwecke abtrennt, wobei der zusätzliche Strahlteiler vorzugsweise nach Anspruch 17 im Strahlengang der emittierten Laserstrahlung angeordnet ist.

Bevorzugte und vorteilhafte Ausgestaltungen des Senders nach Anspruch 17 gehen aus den Ansprüchen 18 und 19 hervor.

Bei einem erfindungsgemäßen Lasersender ist eine Wellenlängenabstimmung durch laterales Verschieben des gesamten Resonators gegenüber dem Halbleiterlaser möglich. Eine Feinabstimmung ist durch Anpassung der Resonatorlänge, d.h. des optischen Abstandes zwischen dem Halbleiterlaser und der Gittereinrichtung, möglich. Beispielsweise beträgt bei einer Wellenlänge von 1,3 $\mu$m und einem optischen Weg von 15 mm im externen Resonator die Frequenzänderung 15 Ghz/$\mu$m.

Da die Linienbreite des sich ergebenden Einmodenspektrums der Länge des externen Resonators umgekehrt proportional ist (siehe IEEE J. of Quant. Electronics, QE-20 (1984) S. 486ff), kann eine vor der Gitteranordnung angeordnete Gradientenlinse um ein Vielfaches ihrer sog. "Pitch"-Länge verlängert werden, um kleinere Linienbreiten zu erzielen. Die Strahlqualität wird davon nicht beeinflußt, ebensowenig die Stabilität der Anordnung.

Die mikrooptische Ausführung des erfindungsgemäßen Lasersenders läßt sich sehr kompakt aufbauen.

Ausführungsbeispiele der Erfindung sind - schematisch in den Figuren dargestellt und werden in der folgenden Beschreibung näher erläutert. Von den Figuren zeigen:

Fig. 1 eine Seitenansicht einer mikrooptischen Ausführung des Lasersenders mit einem teildurchlässigen Gitter zwischen zwei Prismen und mit zwei Gradientenlinsen,

Fig. 2 eine Seitenansicht einer Ausführung des Lasersenders mit freier Strahlausbreitung,

Fig. 3 eine Seitenansicht einer mikrooptischen Ausführung des Lasersenders mit einem reflektierenden Gitter, einem Strahlteiler und zwei Gradientenlinsen, und

Fig. 4 eine Seitenansicht einer mirkooptischen Ausführung eines Lasersenders auf der Basis der Ausführung nach Fig. 1 mit einem zusätzlichen Strahlteiler und einer Fokussierungsoptik des für Monitorzwecke abgetrennten Teils der Laserstrahlung.

Bei der mikrooptischen Ausführung nach Fig. 1 des Lasersenders LS ist im Strahlengang St der von dem Halbleiterlaser HL divergent ausgesandten Laserstrahlung eine kolllimierte Gradientenlinse KO angeordnet, welche die divergente Strahlung zu einer im wesentlichen parallelen Strahlung kollimiert. Die Gradientenlinse KO ist endseitig an einer dem Halbleiterlaser HL zugekehrten und senkrecht zur Achse A des Strahlengangs St angeordneten

Seitenfläche SF0 eines transparenten Prismas PK fixiert. Auf einer von dem Halbleiterlaser HL abgekehrten und schräg in einem Winkel zur Achse A angeordneten Seitenfläche SF dieses Prismas PK ist ein teildurchlässiges optisches Gitter TG, beispielsweise in Form eines Phasengitters, beispielsweise mit Sägezahnprofil, ausgebildet. Auf der von dem Halbleiterlaser HL abgekehrten Seite des Prismas PK ist ein zweites transparentes Prisma PK2 angeordnet, welches das Prisma PK zu einem transparenten Quader ergänzt. Das Gitter TG könnte auch auf diesem zweiten Prisma PK ausgebildet sein.

Die Gittereinrichtung GE ist durch diese beiden Prismen PK und PK1 und dem Gitter TG gebildet.

Auf einer von dem Halbleiterlaser HL abgekehrten Seitenfläche SF2 des zweiten Prismas PK2 ist eine fokussierende Gradientenlinse FO mit einer ihrer Endflächen fixiert, die den durch das Gitter TG und das zweite Prisma PK2 hindurchgegangenen Teil St2 der Laserstrahlung auf eine Koppelstelle KS fokussiert. Die Länge L dieser Gradientenlinse FO ist so gewählt, daß der Fokus F des fokussierten Teils St2 der Laserstrahlung mit der von dem Halbleiterlaser HL abgekehrten Endfläche EF der Gradientenlinse FO zusammenfällt.

Dies hat den Vorteil, daß eine an der Koppelstelle KS anzukoppelnde Systemfaser SyF, welche die Ausgangsleistung des Senders LS fortleitet, direkt an die Gradientenlinse FO stoßgekoppelt werden kann, so wie es in der Figur 1 dargestellt ist.

Die Gittereinrichtung GE in Form der doppelten Prismenanordnung gewährleistet einen einfachen Strahlengang und damit einen guten Koppelwirkungsgrad in die Systemfaser SyF.

Das Gitter TG leitet auch einen - schmalbandigen Teil St1 der vom Halbleiterlaser HL emittierten Laserstrahlung zum Halbleiterlaser HL zurück. Die wellenlängenselektive Wirkung des Gitters TG wird durch die fest verbundene kollimierende Gradientenlinse KO optimiert, da diese Linse KO bei geeignetem Abstand von dem Halbleiterlaser HL einen kollimierten Strahl St erzeugt. Durch die Kombination aus der Gradientenlinse KO und der Gittereinrichtung GE wird nur ein schmaler Wellenlängenbereich in sich reflektiert und wieder auf den Halbleiterlaser HL fokussiert.

Durch die verwendeten Bauelemente ist die Anordnung nach Fig. 1 sehr kompakt aufgebaut.

Die Ausführung nach Fig. 2 des Lasersenders mit freier Strahlausbreitung entspricht in Bezug auf die Gittereinrichtung GE der mikrooptischen Ausführung nach Fig. 1, d. h. das Gitter TG dieser Gittereinrichtung GE ist ein teildurchlässiges Gitter. Die Kollimierungsoptik KO bei der Ausführung nach Fig. 2 besteht aus einem im Strahlengang St der vom Halbleiterlaser HL divergent abgestrahlten Laserstrahlung angeordneten Mikroskopobjektiv, das die divergente Laserstrahlung in einen Parallelstrahl umwandelt, der sich hinter dem Objektiv frei ausbreitet. In diesem freien Strahlengang St der Laserstrahlung ist die Gittereinrichtung GE angeordnet. Diese Gittereinrichtung GE besteht aus einem im Winkel schräg zur Achse A des Strahlenganges St angeordneten quaderförmigen transparenten Körper PK1 und aus dem teildurchlässigen Gitter TG, das hier beispielsweise auf einer dem Halbleiterlaser HL zugekehrten Seitenfläche SF1 des quaderförmigen Körpers PK1 ausgebildet ist, beispielsweise in Form eines Phasengitters.

Der von dem Gitter TG zum Halbleiterlaser HL zurückgeleitete Teil St1 der Laserstrahlung wird von dem Mikroskopobjektiv KO auf den Halbleiterlaser HL fokussiert. Der durch das Gitter TG und den quaderförmigen Körper PK1 hindurchgegangene Teil St2 der Laserstrahlung wird durch eine Fokussierungsoptik FO auf die Koppelstelle KS fokussiert. Diese Fokussierungsoptik FO kann auch einen Teil der zugeführten Strahlung ausblenden. Sie kann in die Gittereinrichtung GE integriert sein und wie bei der Ausführung nach Fig. 1 eine Gradientenlinse sein, deren Länge entsprechend gewählt ist, so daß der Fokus F des von ihr fokussierten Teils St2 mit der von dem Halbleiterlaser HL abgekehrten Endfläche EF zusammenfällt.

Bei der Ausführung nach Fig. 2 hängt der maximale Betrag der auskoppelbaren Leistung von der Qualität der Kopplung über das Mikroskopobjektiv ab, sowie von den Reflexionseigenschaften des Gitters TG. Änderungen der Resonatorlänge und der Rückkoppelstärke sind bei dieser Ausführung leicht möglich.

Es sei darauf hingewiesen, daß in vielen bereits bekannten Anordnungen zur Erzielung schmaler Linienbreiten und von Einmodigkeit die freie Strahlausbreitung mit Rückkopplung durch ein Gitter in Littrow-Konfiguration praktiziert wird (siehe dazu beispielsweise Electron. Lett. 19 (1983) S. 110-112; IEEE J. Quant. Electr. QE-18 (1982) S. 259 ff; Electron. Lett. 21 (1985) S. 658-5659). All diese Anordnungen benutzen die zweiseitige Ankopplung an den Halbleiterlaser, bei welcher die Ausgangsleistung des Senders auf einer Seite des Halbleiterlasers entnommen und der externe Resonator auf der anderen Seite dieses Lasers angekoppelt ist.

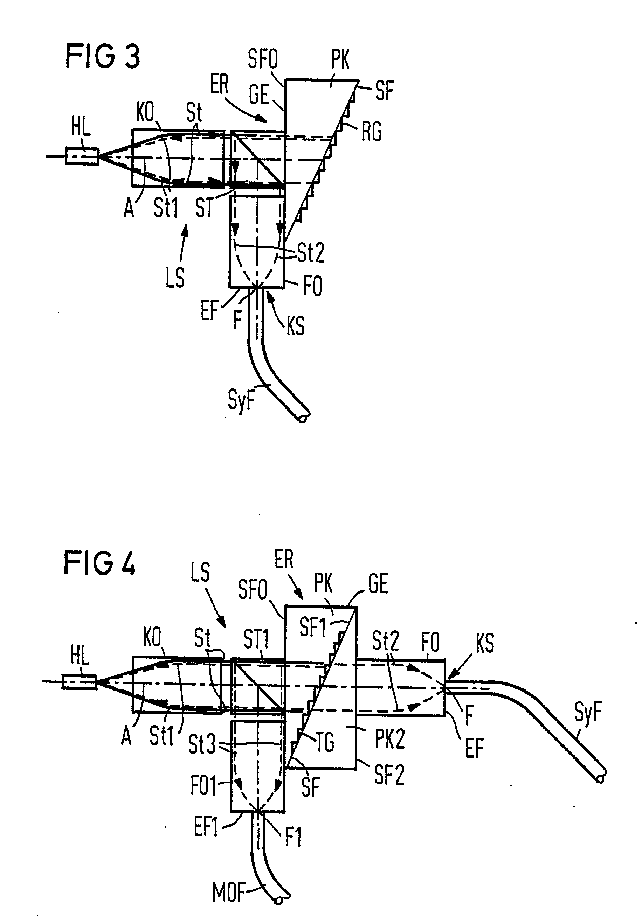

Die mikrooptische Ausführung nach Fig. 3 des Lasersenders unterscheidet sich von der Ausführung nach Fig. 1 im wesentlichen dadurch, daß das Gitter der Gittereinrichtung GE ein reflektierendes Gitter RG ist, das ein möglichst hohes Reflexionsvermögen haben soll. Wie bei der Ausführung nach Fig. 1 wird die divergente Laserstrahlung durch die Gradientenlinse KO kollimiert und die Gittereinrichtung GE besteht aus dem transparenten Prisma PK, auf dessen von dem Halbleiterlaser HL abgekehrten Seitenfläche SF das reflektierende Gitter RG, beispielsweise in Form eines reliefartigen Gitters mit Sägezahnprofil aufgebracht ist.

Zum Auskoppeln der Ausgangsleistung des Lasersenders LS ist ein Strahlteiler ST erforderlich, der zweckmäßigerweise zwischen der Gradientenlinse KO und dem Prisma PK im Strahlengang St der Laserstrahlung angeordnet ist und der einen Teil St2 dieser Laserstrahlung aus dem Strahlengang St beispielsweise im Winkel von 90° zur Achse A herauslenkt. Der Strahlteiler ST wird zweckmäßigerweise am Prisma PK, beispielsweise an der dem Halbleiterlaser HL zugekehrten Seitenfläche SF0 fixiert und kann aus einem Strahlteilerwürfel bestehen.

Der herausgelenkte Teil St2 der Laserstrahlung wird durch eine Fokussierungsoptik FO auf eine Koppelstelle KS fokussiert. Die Fokussierungsoptik FO wird ebenfalls zweckmäßigerweise an dem Prisma PK fixiert. Sie kann wie bei den Ausführungen nach Fig. 1 und Fig. 2 aus einer Gradientenlinse entsprechender Länge bestehen, bei der also der Fokus F des fokussierten herausgelenkten Teils St2 der Laserstrahlung mit der von dem Strahlteiler ST abgekehrten Endfläche EF zusammenfällt. Die Fixierung der Gradientenlinse erfolgt zweckmäßigerweise so, daß ihre Mantelfläche an der dem Halbleiterlaser HL zugekehrten Seitenfläche SF0 des Prismas PK fixiert wird.

Der Strahlteiler ST lenkt auch einen Anteil des zum Halbleiterlaser HL zurückgeleiteten Teil St1 der Laserstrahlung ab, der in der Fig. 3 nicht eingezeichnet und ausgenutzt ist.

Auch diese Ausführung nach Fig. 3 des Lasersenders LS ist sehr kompakt aufgebaut.

Die mikrooptische Ausführung nach Fig. 4 des Lasersenders LS unterscheidet sich von der Ausführung nach Fig. 1 lediglich dadurch, daß zwischen der Kollimierungsoptik KO und der Gittereinrichtung GE ein zusätzlicher Strahlteiler ST1 im Strahlengang St der Laserstrahlung angeordnet ist, der einen Teil St3 dieser Laserstrahlung für Monitorzwecke abtrennt, und daß im Strahlengang dieses abgetrennten Teils St3 eine Fokussierungsoptik FO1 angeordnet ist. Der zusätzliche Strahlteiler ST1 kann wie der Strahlteiler ST bei der Ausführung nach Fig. 3 an dem Prisma PK fixiert und ein Strahlteilerwürfel sein. Auch die Fokussierungsoptik FO1 kann wie die Fokussierungsoptik FO der Ausführung nach Fig. 3 an dem Prisma PK fixiert und eine Gradientenlinse sein, bei welcher der Fokus F1 des fokussierten abgetrennten Teils St3 der Laserstrahlung mit der von dem zusätzlichen Strahlteiler St1 abgekehrten Endfläche EF1 zusammenfällt. Dadurch kann eine Monitorfaser MoF direkt an die Fokussierungsoptik FO1 stoßgekoppelt werden.

Auch die Ausführung nach Fig. 4 zeichnet sich durch einen sehr kompakten Aufbau aus.

In jeder Ausführung des Lasersenders kann eine Anordnung für Monitorzwecke, wie sie in der Fig. 4 beispielsweise dargestellt ist, vorgesehen werden.

Es sei abschließend noch einmal darauf hingewiesen, daß der beesondere Vorteil des hier beschriebenen Lasersenders in der Abstimmbarkeit des Emissionsspektrums durch das Gitter und die Resonatorlänge liegt.

Es ist zweckmäßig, die von dem externen Resonator abgekehrte Seite des Halbleiterlasers zu verspiegeln. Dadurch steigt die optische Leistung bei gleichem Pumpsystem aufgrund der Schwellstromerniedrigung und die Empfindlichkeit bezüglich parasitärer Reflexionen sinkt. Dies gilt für alle Lasersender mit externem Resonator und einseitiger Auskopplung, d.h. bei denen die Ausgangsleistung des Senders auf der Seite des Resonators entnommen wird.


## Ansprüche

1. Schmalbandiger Lasersender (LS) mit einem Halbleiterlaser (HL) und einem an dem Halbleiterlaser (HL) gekoppelten externen optischen Resonator (ER), wobei eine Ausgangsleistung des Senders (LS) dem Resonator (ER) entnehmbar ist, **dadurch gekennzeichnet,** daß der Resonator (ER) aus einer im Strahlengang (St) einer von dem Halbleiterlaser (HL) emittierten Laserstrahlung angeordneten optischen Gittereinrichtung (GE) besteht, die einen Teil (St1) der zugeführten Laserstrahlung zurück zum Halbleiterlaser (HL) und einen anderen Teil (St2) dieser Strahlung zu einer Koppelstelle (KS) leitet, an der dieser andere Teil (St2) als Ausgangsleistung entnehmbar ist.

2. Sender nach Anspruch 1, **dadurch gekennzeichnet,** daß die Gittereinrichtung (GE) ein teildurchlässiges optisches Gitter (TG) aufweist, von dem der schmalbandige Teil (St1) der Laserstrahlung in Richtung zurück zum Halbleiterlaser (HL) gebeugt und der durchgelassene andere Teil (St2) dieser Strahlung in Richtung zur Koppelstelle (KS) abgestrahlt ist.

3. Sender nach Anspruch 2, **dadurch gekennzeichnet,** daß das teildurchlässige optische Gitter (TG) auf einer Seitenfläche (SF) eines prismatischen Körpers (PK, PK1) aus einem für die Laserstrahlung transparenten Material ausgebildet ist.

4. Sender nach Anspruch 3, **dadurch gekennzeichnet,** daß das teildurchlässige optische Gitter (TG) ein Phasengitter ist.

5. Sender nach Anspruch 1, **dadurch gekennzeichnet,** daß die Gittereinrichtung (GE) ein reflektierendes Gitter (RG), von dem der schmalbandige Teil (St1) in Richtung zurück zum Halbleiterlaser (HL) gebeugt ist, und einen im Strahlengang (St) der emittierten Laserstrahlung angeordneten Strahlteiler (ST) aufweist, der einen Anteil dieser Strahlung abtrennt und als den anderen Teil (St2) in Richtung zur Koppelstelle (KS) lenkt.

6. Sender nach Anspruch 5, **dadurch gekennzeichnet,** daß das reflektierende Gitter (RG) auf einer Seitenfläche (SF) eines prismatischen Körpers (PK) ausgebildet ist.

7. Sender nach Anspruch 6, **dadurch gekennzeichnet,** daß der prismatische Körper (PK) aus einem für die Laserstrahlung transparenten Material besteht, der im Strahlengang (St) der emittierten Laserstrahlung angeordnet ist.

8. Sender nach Anspruch 7, **dadurch gekennzeichnet,** daß der Strahlteiler (St) an dem prismatischen Körper (PK) fixiert ist.

9. Sender nach einem der vorhergehenden Ansprüche, **dadurch gekennzeichnet,** daß im Strahlengang (St) der emittierten Laserstrahlung zwischen dem Halbleiterlaser (HL) und der Gittereinrichtung (GE) eine Kollimierungsoptik (KO) zum Kollimieren der Laserstrahlung angeordnet ist, die zugleich den zum Halbleiterlaser (HL) zurückgeleiteten schmalbandigen Teil (St1) der Laserstrahlung auf den Halbleiterlaser (HL) fokussiert.

10. Sender nach Anspruch 9, **dadurch gekennzeichnet,** daß die Kollimierungsoptik (KO) aus einer Gradientenlinse besteht.

11. Sender nach Anspruch 7 oder 8 und Anspruch 10, **dadurch gekennzeichnet,** daß die Gradientenlinse (KO) an dem prismatischen Körper (PK) fixiert ist.

12. Sender nach Anspruch 9, **dadurch gekennzeichnet,** daß die Kollimierungsoptik (KO) aus einem in dem zwischen dem Halbleiterlaser (HL) und der Gittereinrichtung (GE) freien Strahlengang (St) der Laserstrahlung angeordneten Mikroskopobjektiv besteht.

13. Sender nach einem der vorhergehenden Ansprüche, **dadurch gekennzeichnet,** daß im Strahlengang des der Koppelstelle (KS) zugeleiteten anderen Teils (St2) der Laserstrahlung eine Fokussierungsoptik (FO) zum Fokussieren dieses anderen Teils (St2) auf die Koppelstelle (KS) angeordnet ist.

14. Sender nach Anspruch 13, **dadurch gekennzeichnet,** daß die Fokussierungsoptik (FO) aus einer Gradientenlinse besteht.

15. Sender nach Anspruch 14, **dadurch gekennzeichnet,** daß die Länge (L) der im Strahlengang des der Koppelstelle (KS) zugeleiteten anderen Teils (St2) der Laserstrahlung angeordneten und die Fokussierungsoptik (FO) bildenden Gradientenlinse derart bemessen ist, daß der Fokus (F) dieses anderen Teils (St2) mit einer Endfläche (EF) dieser Gradientenlinse (FO) zusammenfällt.

16. Sender nach Anspruch 14 oder 15, **dadurch gekennzeichnet,** daß die Fokussierungsoptik (FO) an einem im Strahlengang des der Koppelstelle (KS) zugeleiteten anderen Teils (St2) der Laserstrahlung angeordneten prismatischen Körper (PK1) aus für die Laserstrahlung transparentem Material fixiert ist.

17. Sender nach einem der vorhergehenden Ansprüche, **dadurch gekennzeichnet,** daß im Strahlengang (St) der emittierten Laserstrahlung zwischen dem Halbleiterlaser (HL) und der Gittereinrichtung (GE) ein zusätzlicher Strahlteiler (ST1) angeordnet ist, der einen Teil (St3) der Laserstrahlung für Monitorzwecke abtrennt.

18. Sender nach Anspruch 17, **dadurch gekennzeichnet,** daß im Strahlengang des für Monitorzwecke abgetrennten Teils (St3) eine Fokussierungsoptik (FO1) angeordnet ist.

19. Sender nach einem der Ansprüche 3 bis 4 und 9 bis 13 oder 9 bis 13 und 14 bis 16 und Anspruch 18, **dadurch gekennzeichnet,** daß der zusätzliche Strahlteiler (St1) zwischen der Kollimierungsoptik (KO) und der Gittereinrichtung (GE) angeordnet und an dem im Strahlengang (St) der emittierten Laserstrahlung angeordneten prismatischen Körper (PK) fixiert ist, und daß die den für Monitorzwecke abgetrennten Teil (St) der Laserstrahlung fokussierende Fokussierungsoptik (FO1) eine Gradientenlinse ist, die mit ihrer Mantelseite an diesem prismatischem Körper (PK) fixiert ist und deren Länge (L1) so bemessen ist, daß der Fokus (F1) dieses Teils (St3) mit einer Endfläche (EF1) dieser Gradientenlinse zusammenfällt.

FIG 1

FIG 2

FIG 3

FIG 4